# EUROPEAN PATENT SPECIFICATION

(11) **EP 1 914 788 B1**
(45) Date of publication and mention of the grant of the patent: **10.05.2017**
(21) Application number: 07019829.6
(22) Date of filing: 10.10.2007
(51) Int. Cl.: H01J 37/32, H01L 21/67, H01L 21/683, H01L 21/687

(54) **Substrate stage and plasma processing apparatus**
Substratstufe- und Plasmaverarbeitungsvorrichtung
Support de substrat et appareil de traitement à plasma

(30) Priority: 17.10.2006 JP 2006282638
(43) Date of publication of application: 23.04.2008
(73) Proprietor: TOKYO ELECTRON LIMITED, Minato-ku Tokyo 107-8481 (JP)
(72) Inventor: Sugiyama, Hideki, Nirasaki-shi Yamanashi 407-8511 (JP); Okayama, Nobuyuki, Amagasaki-shi Hyogo 660-0891 (JP); Nagayama, Nobuyuki, Nirasaki-shi Yamanashi 407-8511 (JP)
(74) Representative: Hoffmann Eitle

(56) References cited:
- WO-A-2007/043528
- JP-A- 2005 277 369
- US-A1- 2001 003 271
- US-A1- 2002 177 001
- US-A1- 2004 168 640
- US-A1- 2005 193 951
- US-B2- 6 733 624

## Description

### BACKGROUND OF THE INVENTION

### Field of the Invention

The present invention relates to a substrate stage and a plasma processing apparatus, and more particularly, to a substrate stage having a focus ring mounted thereon for surrounding the circumference of a substrate and a plasma processing apparatus including the substrate stage.

### Description of the Related Art

A plasma processing apparatus is for performing plasma processing such as etching on a wafer as a substrate, and comprises a chamber for receiving a wafer, and a stage disposed in the chamber and adapted to be mounted with the wafer. The stage has a wafer mounting surface thereof on which an electrostatic chuck for attracting and holding a wafer thereon is disposed. The electrostatic chuck is made of a conductive material and formed at its entire circumference with a sprayed coating. The plasma processing apparatus can generate a plasma in the chamber, and can use the plasma to etch a wafer attracted and held by the electrostatic chuck.

Some plasma processing apparatus is provided with a ring-shaped member called a focus ring, which is disposed to surround the circumference of a wafer mounted on the stage. The purpose of using the focus ring is to confine the plasma and relax discontinuity caused by an edge surface effect of bias potential in a to-be-processed surface of the wafer to thereby realize uniform and satisfactory processing not only at a central portion of the wafer but also at a circumferential portion of the wafer.

A known focus ring is disposed such that an upper surface of the focus ring is positioned at nearly the same height as the processed surface of the wafer. As a result, nearly the same electric field as that formed above the to-be-processed surface of the wafer is formed above the focus ring, thereby relaxing the discontinuity caused by the edge surface effect of bias potential in the to-be-processed surface of the wafer. As a consequence, plasma sheaths, which are nearly the same in height, are formed above the to-be-processed surface of the wafer and above the focus ring. Due to the presence of such plasma sheaths, ions are perpendicularly incident into the to-be-processed surface of the wafer even at a circumferential portion of the wafer, making it possible to realize uniform and satisfactory processing on the to-be-processed surface of the wafer (refer to National Publication of Translated Version No. 2003-503841 (JP2003503841 or WO00101445), for example).

When the known focus ring is used, the wafer and the focus ring are at nearly the same potential, making it easy for ions to reach the rear surface of the wafer between a circumferential portion of the wafer and an inner circumferential portion of the focus ring. The ions reaching the rear surface of the wafer cause a problem that CF-based polymer or the like can be deposited on the circumferential portion of the rear surface of the wafer.

To obviate this, there has been proposed a focus ring comprised of a ring-shaped lower member made of a dielectric material and a ring-shaped upper member disposed on the lower member and made of a conductive material (see, Japanese Laid-open Patent Publication No. 2005-277369 (JP2005277369), for example). FIG. 4A is an enlarged section view showing a focus ring disposed on an electrostatic chuck on an upper surface of a stage. In the focus ring 19 on the electrostatic chuck 36, a flat portion 21a is formed on the inner circumferential side of an upper surface of an upper member 21 at a height lower than the rear surface of the wafer W. Another flat portion (not shown) is formed on the outer circumferential side of the upper surface of the upper member 21 at a height higher than the to-be-processed surface of the wafer. The upper member 21 is disposed on the lower member 20 such that a predetermined clearance is defined between the upper member 21 and a circumferential portion E of the wafer W.

With use of the focus ring 19, a predetermined potential difference can be produced between the wafer W and the upper member 21. An electric field formed by the potential difference changes a moving path of ions such that the ions do not move toward the rear surface of the circumferential portion E of the wafer W, thereby suppressing CF-based polymer or the like from being deposited, due to the presence of ions, on the rear surface of the circumferential portion E of the wafer W.

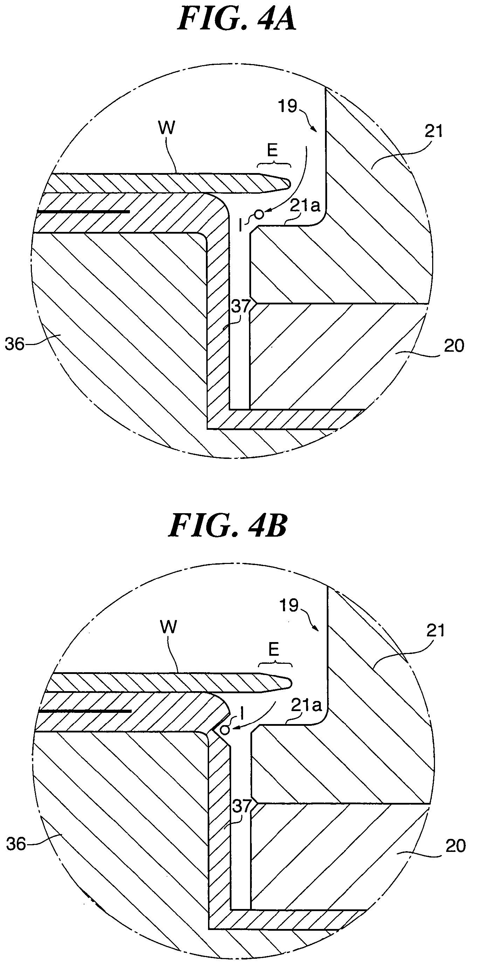

By using the focus ring 19 comprised of the lower member 20 made of a dielectric material and the upper member 21 made of a conductive material as shown in FIG. 4A, it is possible to suppress the deposition of CF-based polymer or the like on the rear surface of the circumferential portion E of the wafer W as described above. However, the electric field formed as shown in FIG. 4A acts to change the moving path of ions I such that the ions I are incident upon a side surface of the electrostatic chuck 36 as shown in FIG. 4B. The ions I incident on the side surface of the chuck 36 sputter and consume the sprayed coating 37 formed on the side surface of the chuck 36. With the elapse of time during which plasma processing is performed in the apparatus, the sprayed coating 37 formed on the side surface of the chuck 36 is gradually consumed. Finally, a conductive member inside the electrostatic chuck 36 is exposed to the processing space. When the conductive member becomes exposed to the processing space, undesired abnormal discharge or the like can occur. To perform normal plasma processing on the wafer W, the electrostatic chuck 36 must be replaced.

As a constituent of the sprayed coating of the electrostatic chuck, alumina (Al₂O₃) has been used. The sprayed coating made of alumina is consumed by the sputtering of ions at a rate of 2.4 µm/h at the maximum. Ordinarily, the alumina formed on the side surface of the electrostatic chuck has a film thickness of 200 to 500 µm, and therefore, the electrostatic chuck must be replaced after each execution of plasma processing for several hundred hours. This increases the running cost of the apparatus and decreases the operating rate of the apparatus, which is a problem. US 2004/0168640 A1 and US6733624 B2 disclose a substrate table for mounting a substrate thereon in a plasma processing apparatus. The substrate table comprises a table main body having an outer peripheral portion and a central portion, the outer peripheral portion being formed lower than the central portion, an electrostatic chuck layer arranged on the central portion, and a focus ring formed to surround the electrostatic chuck layer. In US2004/0168640 A1 a sprayed coating of alumina having a constant film thickness covers an upper surface of said table main body. In US6733624 B2 a sprayed coating of alumina having a varying film thickness covers an upper surface of said table main body, the varying film thickness across said substrate table being in accordance with process requirements, wherein the sprayed coating is thinner on said outer peripheral portion than on an upper surface of said central portion.

### SUMMARY OF THE INVENTION

The present invention provides a substrate stage capable of decreasing the running cost of the plasma processing apparatus described above and increasing the operation rate thereof, and a plasma processing apparatus comprising the substrate stage.

According to a first aspect of the present invention, there is provided a substrate stage adapted to be mounted with a substrate that is to be subjected to plasma processing, according to claim 1. electrostatic chuck having a mounting surface thereof for side surface with an oxide film having a range from 1000 to 2000 µm.

With the substrate stage of the present invention, the substrate placement portion made projected beyond the focus ring placement portion is formed at its side surface with the oxide film having a predetermined film thickness and made of a group 3 element of the periodic system. The oxide film of a group 3 element is highly resistant to plasma. Thus, even when plasma processing is performed for a long time, the oxide film formed on the side surface of the substrate placement portion will never be completely removed. As a result, unlike the known apparatus which requires the replacement of the electrostatic chuck after each execution of plasma processing for several hundred hours, the electrostatic chuck is not required to be replaced even after the execution of plasma processing for a time period which is several times longer than the plasma processing execution time in the known apparatus, thereby reducing the running cost of the apparatus and improving the operation rate of the apparatus.

The oxide film on the side surface of the substrate placement portion can be thicker than the coating formed on the focus ring placement portion so as to cover a focus ring mounting surface of the focus ring placement portion.

In this case, the oxide film on the side surface of the substrate placement portion is thicker than the coating that covers the focus ring mounting surface of the focus ring placement portion. In other words, the focus ring placement portion is formed with a thin coating, making it possible to prevent a reduction in the efficiency of the substrate stage for cooling the focus ring.

The focus ring can be comprised of a ring-shaped lower member made of a dielectric material, and a ring-shaped upper member disposed on the lower member and made of a conductive material, and the upper member can include a first flat portion formed on an inner peripheral side of an upper surface of the upper member at a height lower than a rear surface of the substrate and a second flat portion formed on an outer peripheral side of the upper surface of the upper member at a height higher than a to-be-processed surface of the substrate when the focus ring is placed on the focus ring placement portion.

In this case, the focus ring is comprised of a ring-shaped lower member made of a dielectric material and a ring-shaped upper member disposed on the lower member and made of a conductive material. Furthermore, the upper member includes the first flat portion formed on the inner peripheral side of the upper surface of the upper member at a height lower than the rear surface of the substrate and the second flat portion formed in the outer peripheral side of the upper surface of the upper member at a height higher than the to-be-processed surface of the substrate. As a result, a predetermined potential difference is produced between the circumferential portion of the substrate and the upper member. A moving path of ions is changed due to the presence of an electric field formed by the potential difference, whereby the ions are suppressed from moving toward the rear side of the circumferential portion of the substrate, making it possible to suppress CF-based polymer or the like from being deposited, due to the presence of the ions, on the rear side of the circumferential portion of the substrate.

The substrate placement portion can be made projected at least 5 mm beyond the focus ring placement portion.

In this case, the substrate placement portion is made projected 5 mm or more beyond the focus ring placement portion. As a result, it is possible to optimally set the positional relation between the substrate and the focus ring comprised of the ring-shaped lower member made of a dielectric material and the ring-shaped upper member comprised of a conductive material, which ensures the generation of the predetermined potential difference between the upper member and the circumferential portion of the substrate.

The predetermined film thickness of said oxide film on said side surface of said substrate placement portion is in a range of 1000 to 2000 µm.

In this case, the oxide film of a group 3 element from 1000 to 2000 µm. of the periodic system has a predetermined film thickness which is in a range of 1000 to 2000 µm. As a result, even when the plasma processing is performed in the apparatus for several thousand hours, more specifically, for 3000 hours, the oxide film of the predetermined film thickness will never be completely removed by the sputtering of ions incident on the side surface of the substrate placement portion.

The oxide film on said side surface of said substrate placement portion can be made of yttria.

In this case, the oxide film is made of yttria. Yttria formed on the side surface of the substrate placement portion is removed by the sputtering of ions incident upon the side surface. Since yttria does not include aluminum, it is ensured that particles including aluminum are prevented from being generated in a processing space.

According to a second aspect of this invention, there is provided a plasma processing apparatus comprising the substrate stage according to the first aspect of this invention.

With the plasma processing apparatus of this invention which is provided with the substrate stage of this invention, the above described effects can be attained.

Further features of the present invention will become apparent from the following description of an exemplary embodiment with reference to the attached drawings.

### BRIEF DESCRIPTION OF THE DRAWINGS

FIG. 1 is a sectional view schematically showing the construction of a plasma processing apparatus according to one embodiment of this invention;
FIGS. 2A and 2B are enlarged sectional views each schematically showing the construction of a near-side-wall part of an electrostatic chuck, wherein FIG. 2A is an enlarged sectional view showing an A portion in FIG. 1, and FIG. 2B is an enlarged sectional view showing the same portion of a known electrostatic chuck disposed in the plasma processing apparatus shown in FIG. 1;
FIG. 3 is a graph showing a result of measurement of a side wall removed amount with elapse of plasma processing time in a working example of this invention and that in a prior art example; and
FIGS. 4A and 4B are enlarged sectional views each schematically showing the construction of a near-side-wall part of a known electrostatic chuck, wherein FIG. 4A is an enlarged sectional view of a focus ring mounted on the electrostatic chuck on an upper surface of a stage, and FIG. 4B is an enlarged sectional view for explaining a state where the side wall of the electrostatic chuck is removed by the sputtering of ions incident on the side wall of the chuck.

### DETAILED DESCRIPTION OF THE PREFERRED EMBODIMENT

The present invention will now be described in detail below with reference to the drawings showing a preferred embodiment thereof.

First, a plasma processing apparatus according to the preferred embodiment of this invention will be described.

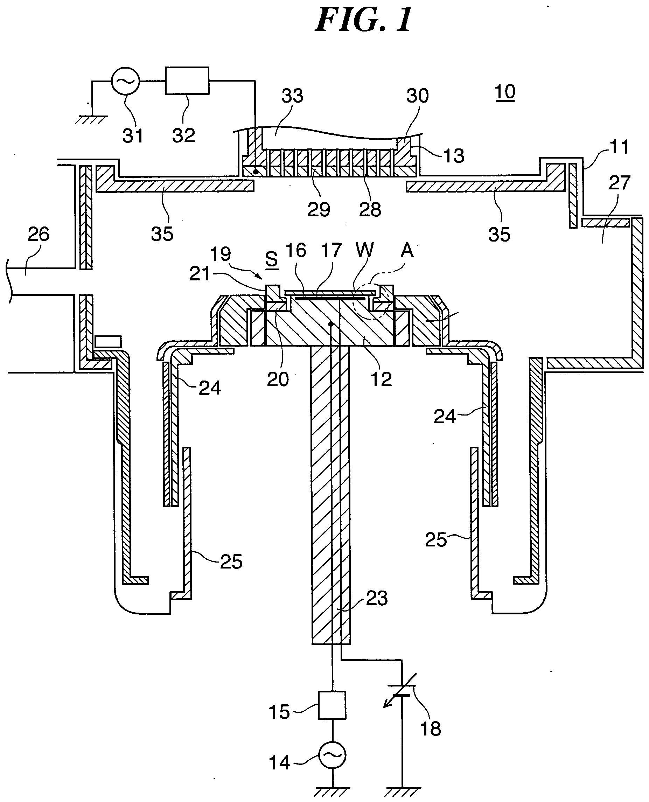

FIG. 1 is a sectional view schematically showing the construction of the plasma processing apparatus of the preferred embodiment.

In FIG. 1, the plasma processing apparatus 10 is configured as an etching apparatus for performing plasma processing, such as reactive ion etching, on semiconductor device wafers W (hereinafter referred to as the "wafers W"), and comprises a chamber 11 used as a processing chamber and made of a metal such as aluminum or stainless steel.

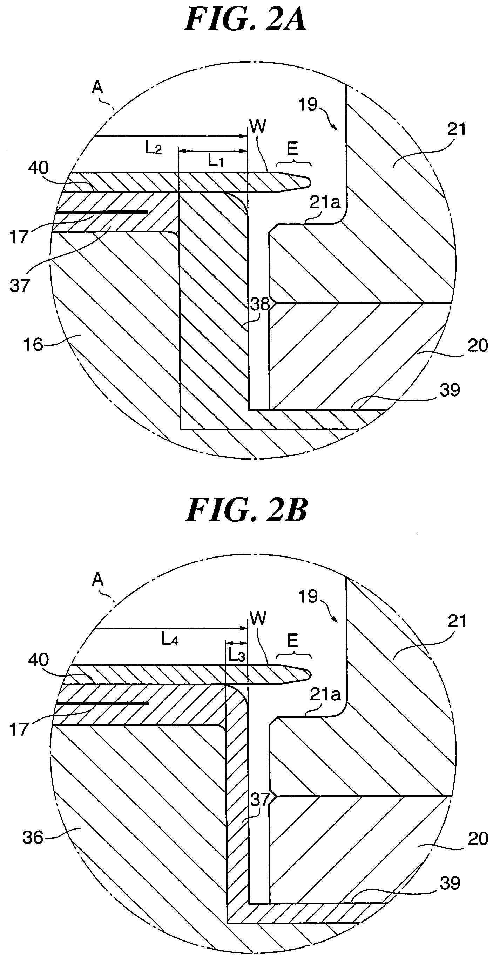

In the chamber 11, a lower electrode 12 as a substrate stage is disposed. The lower electrode 12 is adapted to be mounted with a wafer W, which is for example 300 mm in diameter, the lower electrode being arranged for vertical motion in the chamber 11 together with a wafer W mounted on the electrode 12. A shower head 13 is disposed in a ceiling portion of the chamber 11 so as to face the lower electrode 12 and is adapted to supply processing gas, described later, into the chamber 11. The lower electrode 12 has a focus ring placement portion 39 (refer to FIGS. 2A and 2B) on which a focus ring 19, described later, is disposed to surround the circumference of a wafer W mounted on the lower electrode 12, and a wafer mounting portion 40 (see FIGS. 2A and 2B) disposed inwardly of the focus ring placement portion 39 so as to upwardly project more than 5 mm beyond the focus ring placement portion 39.

A lower high-frequency power source 14 is connected to the lower electrode 12 via a lower matcher 15 and is adapted to supply predetermined high frequency power to the lower electrode 12. The lower matcher 15 can reduce the reflection of high frequency power from the lower electrode 12 to maximize the efficiency of incidence of high frequency power to the lower electrode 12.

An electrostatic chuck (ESC) 16 for attracting a wafer W through an electrostatic attracting force is disposed in an upper part of the lower electrode 12, and incorporates therein an ESC electrode plate 17 comprised of electrode films stacked in layers. A DC power source 18 is electrically connected to the ESC electrode plate 17. The electrostatic chuck 16 can attract and hold a wafer W on its upper surface through a Coulomb force or a Johnsen-Rahbek force generated by the application of a DC voltage from the DC power source 18 to the ESC electrode plate 17. A focus ring 19 is disposed on the circumference of the electrostatic chuck 16. The focus ring 19 is comprised of a ring-shaped lower member 20 made of a dielectric material such as silica (SiO₂), and a ring-shaped upper member 21 disposed on the lower member 20 and made of a conductive material such as silicon (Si). The focus ring 19 can uniformly converge the plasma generated above the lower electrode 12 toward a to-be-processed surface of a wafer W.

A support 23 is disposed below the lower electrode 12 and extended downward from a lower part of the lower electrode 12. The support 23 supports the lower electrode 12 and can vertically move the lower electrode 12 with rotation of a ball screw, not shown. The support 23 is covered by first and second covers 24 and 25, thereby being isolated from the ambient in the chamber 11.

A transfer port 26 for a wafer W and an exhaust section 27 are provided at a side wall of the chamber 11. A wafer W can be transferred in and out of the chamber 11 via the transfer port 26 using a transfer arm (not shown) of an LLM (load lock module), not shown, which is disposed adjacent to the plasma processing apparatus 10. The exhaust section 27 is connected to an exhaust system comprised of an exhaust manifold, an APC (automatic pressure control) valve, a DP (dry pump), a TMP (turbo molecular pump), etc. , none of which is shown. Air and the like in the chamber 11 can be discharged to the outside through the exhaust section 27.

In the plasma processing apparatus 10, when a wafer W is to be transferred into the chamber 11, the lower electrode 12 is moved downward to the same height as the transfer port 26. When the wafer W is to be subjected to plasma processing, on the other hand, the lower electrode 12 is moved upward to a wafer W processing position. FIG. 1 shows a positional relation between the transfer port 26 and the lower electrode 12 when the wafer W is transferred into the chamber 11.

The shower head 13 includes a disk-shaped upper electrode (CEL) 29 formed with a number of gas-passing holes 28 facing the processing space S defined above the lower electrode 12, and an electrode support 30 disposed above the upper electrode 29 and removably supporting the upper electrode 29. The upper electrode 29 has a surface thereof facing the processing space S and having an outer peripheral portion covered by an inner peripheral portion of a sealed ring 35. The sealed ring 35 is an annular member disposed in the ceiling portion of the chamber 11. The sealed ring 35 is made of, for example, quartz or the like, and protects screws (not shown) from the plasma. These screws are disposed on the outer peripheral portion of the upper electrode 29 and used to fix the upper electrode 29 to the ceiling portion of the chamber 11.

An upper high-frequency power supply 31 is connected to the upper electrode 29 via an upper matcher 32. The upper high-frequency power supply 31 can supply predetermined high frequency power to the upper electrode 29. The upper matcher 32 can reduce the reflection of high frequency power from the upper electrode 29, to thereby maximize the efficiency of incidence of the high frequency power into the upper electrode 29.

A buffer chamber 33 is provided inside the electrode support 30, and a processing gas introduction pipe (not shown) is connected to the buffer chamber 33. A processing gas comprised of oxygen gas (O₂), argon gas (Ar), or carbon tetrafluoride (CF₄), or a mixture thereof is supplied from, for example, the processing gas introduction pipe to the buffer chamber 33, and is supplied via the gas-passing holes 28 into the processing space S.

In the chamber 11 of the plasma processing apparatus 10, high frequency power is supplied to the lower and upper electrodes 12, 29, as described above. Upon supply of high frequency power, a plasma comprised of ions, radicals, etc. , is generated from the processing gas in the processing space S. The generated plasma is uniformly converged by the focus ring 19 onto the to-be-processed surface of the wafer W, whereby the to-be-processed surface of the wafer W is physically or chemically etched uniformly.

FIGS. 2A and 2B are enlarged sectional views each schematically showing the construction of a near-side-wall part of an electrostatic chuck. FIG. 2A is an enlarged section view of an A portion in FIG. 1, and FIG. 2B is an enlarged sectional view showing the same portion of a known electrostatic chuck disposed in the plasma processing apparatus 10 in FIG. 1.

As shown in FIG. 2A, the focus ring 19 comprised of the lower and upper members 20, 21 is disposed on the circumference of the electrostatic chuck 16, as described above. A flat portion 21a (first flat portion) is formed on an inner peripheral side of an upper surface of the upper member 21 and is located at a height lower than the rear surface of a wafer W attracted and held by the electrostatic chuck 16. On an outer peripheral side of the upper surface of the upper member 21, a flat portion (refer to FIG. 1) (second flat portion) is formed at a height higher than the to-be-processed surface of the wafer W. A predetermined clearance is defined between the upper member 21 and a circumferential portion E of the wafer W. Since the wafer mounting portion 40 disposed inwardly of the focus ring placement portion 39 projects 5 mm or more beyond the focus ring placement portion 39, as described above, it is possible to optimally set the positional relation between the focus ring 19 and the wafer W. More specifically, the distance between the flat portion 21a and the rear surface of the wafer W can be set to an optimum value.

As described above, a plasma comprised of ions, radicals, etc. is generated in the chamber 11 of the plasma processing apparatus 10. The generated plasma is converged onto the to-be-processed surface of the wafer W by the focus ring 19, and physically or chemically etches the to-be-processed surface of the wafer W. At that time, the upper member 21 made of a conductive material is isolated from the electrostatic chuck 16 by means of the lower member 20 made of a dielectric material, whereby a predetermined potential difference is caused between the upper member 21 of the focus ring 19 and the circumferential portion E of the wafer W. An electric field produced by the potential difference acts to change the moving path of ions so as to suppress the ions from moving toward the rear surface side of the circumferential portion E of the wafer W, making it possible to suppress CF-based polymer or the like from being deposited, due to the presence of ions, on the rear surface side of the circumferential portion E of the wafer W.

However, the ions having been changed in their moving path by the electric field are incident on the side wall (side surface) of the electrostatic chuck 16. The incident ions sputter and remove the sprayed coating formed on the side wall of the electrostatic chuck 16, whereby the sprayed coating is consumed. If the sprayed coating formed on the side wall is completely removed, and an electrically conductive member within the electrostatic chuck 16 is exposed to the processing space S, undesired abnormal discharge can be caused by the exposure of the conductive member. To continue normal plasma processing on the wafer W, the electrostatic chuck 16 must be replaced.

In this embodiment, an oxide film of a group 3 element of the periodic system, such as for example, an yttria (Y₂O₃) film 38, is formed as a sprayed coating on the side wall of the electrostatic chuck 16, as shown in FIG. 2A, to have a film thickness L1 which is in the range of 1000 to 2000 µm.

Contrary to this, on the side wall of the known electrostatic chuck 36, there is formed a sprayed coating 37 such as for example alumina (Al₂O₃) whose film thickness L3 is in the range of 200 to 500 µm, as shown in FIG. 2B.

As compared to the alumina film, the oxide film of a group 3 element of the periodic system is hard to be sputtered by ions and is thus highly resistant to the plasma. More specifically, the alumina film as the sprayed coating 37 is removed by the sputtering of ions at a rate of 2. 4 µm/h at the maximum. On the other hand, the yttria film 38 is removed by the sputtering of ions only at a rate of 0.74 µm/h at the maximum. By forming the yttria film 38 as the sprayed coating, it is possible to remarkably delay a conductive member inside the electrostatic chuck 16 from being exposed.

The electrostatic chuck 16 of this embodiment is configured to have a diameter L2 which is the same as the diameter L4 of the known electrostatic chuck 36, and attain the same functions as those of the known electrostatic chuck 36 with respect to the wafer W.

In this embodiment, a sprayed coating made of alumina or yttria is formed also on the focus ring placement portion 39 of the electrostatic chuck 16. To prevent a reduction in the efficiency of the electrostatic chuck 16 for cooling the focus ring 19, it is preferable that this sprayed coating should not be thickly formed. In this embodiment, the sprayed coating is formed to have a thickness in the range of 200 to 500 µm, as in the prior art. The sprayed coating formed on the side wall of the electrostatic chuck 16 is thicker than the sprayed coating that covers the focus ring mounting surface of the focus ring placement portion 39.

For convenience of explanation, the embodiment shown in FIG. 2A will be referred to as the working example, whereas the known arrangement shown in FIG. 2B will be referred to as the prior art example.

The following is a comparison between the working example and the prior art example.

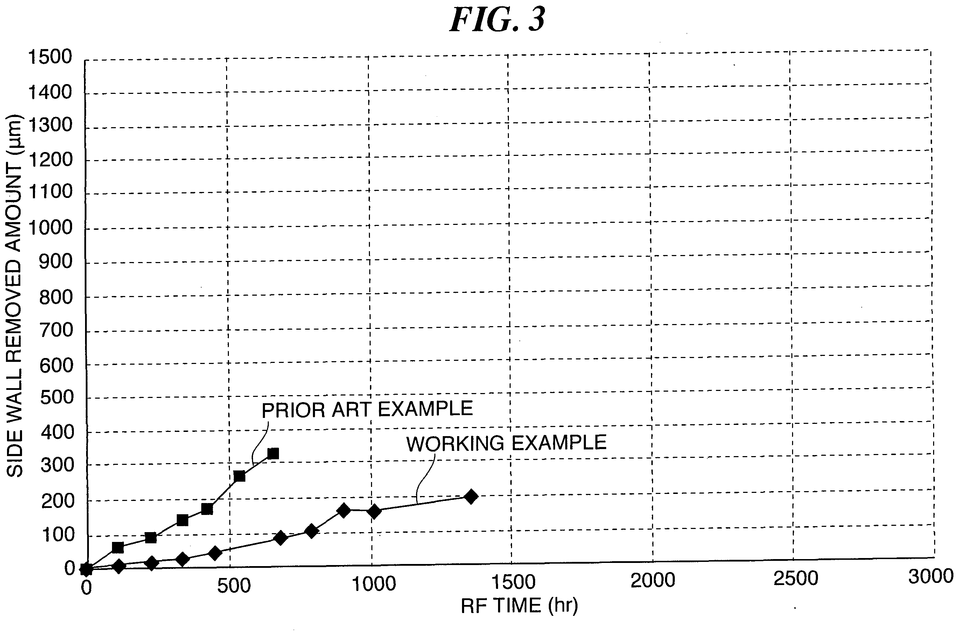

[Working Example] As described above, a plasma comprised of ions, radicals, etc. is generated in the chamber 11 of the plasma processing apparatus 10. Ions in the plasma are incident on the side wall of the electrostatic chuck 16. The incident ions sputter and remove the yttria film 38 formed as the sprayed coating on the side wall of the electrostatic chuck 16. The removed amount of the yttria film 38 (side wall removed amount (µm)) was measured with elapse of plasma processing time (RF Time (hr)), as shown by black rhombus marks in FIG. 3.

[Prior art example] As in the working example, the removed amount of the alumina film as the sprayed coating 37 was measured with elapse of plasma processing time (RF Time (hr)), as shown by black square marks in FIG. 3.

It is understood from the graph of FIG. 3, that the alumina film as the sprayed coating 37 formed on the side wall of the electrostatic chuck 36 in the prior art example was completely removed by the execution of plasma processing for several hundred hours. On the other hand, the yttria film 38 formed on the side wall of the electrostatic chuck 16 of the working example was not completely removed by the execution of plasma processing for several hundred hours. After execution of the plasma processing for about 1400 hours, a side wall removed amount of about 200 µm was measured. From this, it is estimated that execution of plasma processing for 3000 hours will result in a side wall removed amount of less than 1000 µm, and that the yttria film 38 (whose film thickness L1 is in the range of 1000 to 2000 µm) serving as the side wall will not completely be removed.

With the working example in which the yttria film 38 of a film thickness varying from 1000 to 2000 µm is formed on the side wall of the electrostatic chuck 16, the yttria film will never completely be removed by the sputtering of ions incident on the side wall even when the plasma processing is carried out in the apparatus for several thousand hours, specifically, for 3000 hours. As a result, unlike the prior art example which requires replacement of the electrostatic chuck 36 after each execution of plasma processing for several hundred hours, the working example does not require replacement of the electrostatic chuck 16 even when the plasma processing is performed for 3000 hours, resulting in a reduced running cost and an improved operation rate of the apparatus.

According to examples not forming part of the claimed invention, it should be noted that for the yttria film formed on the side wall of the electrostatic chuck it is not inevitably necessary to have a film thickness falling within the range of 1000 to 2000 µm. The yttria film may be formed to have a film thickness of 2000 µm or more. The present inventors confirmed that cracks were produced when an electrostatic chuck, formed at its side wall with an yttria film of 2700 µm thickness, was heated to 110 degrees C, whereas no cracks were produced when an electrostatic chuck, formed at its side wall with an yttria film of 2000 µm thickness, was heated to 120 degrees C. From the viewpoint of attaining a target service life of the electrostatic chuck or the like, it was estimated that an optimum film thickness of the yttria film varied from 1000 to 2000 µm. It is expected that the yttria film having a thickness of 2000 µm or more can easily be formed by forming an undercoat made of a metal or the like on a surface of a base (conductive member) of the electrostatic chuck.

In the prior art example, the alumina film as the sprayed coating 37 is formed on the side wall of the electrostatic chuck 36, and the alumina film as the sprayed coating 37 formed thereon is removed by the sputtering of ions incident on the side wall of the chuck. The prior art example poses a problem that aluminum (Al)-containing particles such as aluminum fluoride (AlF₃) are generated in the processing space S when the alumina film as the sprayed coating 37 is being removed, and the generated particles can be adhered to wafers W, resulting in defects in finally fabricated semiconductor device products.

On the other hand, with the working example in which the yttria film 38 is formed on the side wall of the electrostatic chuck 16, it is expected that aluminum-containing particles can reliably be prevented from being generated in the processing space S.

## Claims

1. A substrate stage adapted to be mounted with a substrate that is to be subjected to plasma processing, comprising a focus ring placement portion (39) adapted to be mounted with a focus ring (19) that surrounds a circumference of the substrate mounted on the substrate stage and a substrate placement portion made projected beyond said focus ring placement portion (39) at a location inward of said focus ring placement portion (39), said substrate placement portion being provided at its upper portion with an electrostatic chuck (16) having a mounting surface thereof for attracting and holding the substrate, wherein said substrate placement portion is formed at its side surface with an oxide film having a predetermined film thickness, and wherein said focus ring placement portion (39) is formed with a coating, **characterized in that** said predetermined film thickness of said oxide film on said side surface of said substrate placement portion is in a range of 1000 to 2000 µm, said oxide film being made of a group 3 element of the periodic system, and that said coating on said focus ring placement portion (39) has a thickness in a range of 200 to 500 µm.

2. The substrate stage according to claim 1, wherein the coating of said focus ring placement portion (39) is formed on said focus ring placement portion (39) so as to cover a focus ring mounting surface of said focus ring placement portion (39).

3. The substrate stage according to claim 1, wherein the focus ring is comprised of a ring-shaped lower member (20) made of a dielectric material, and a ring-shaped upper member (21) disposed on the lower member (20) and made of a conductive material, and
wherein the upper member (21) includes a first flat portion formed on an inner peripheral side of an upper surface of the upper member (21) at a height lower than a rear surface of the substrate and a second flat portion formed on an outer peripheral side of the upper surface of the upper member (21) at a height higher than a to-be-processed surface of the substrate when the focus ring (19) is placed on said focus ring placement portion (39).

4. The substrate stage according to claim 1, wherein the substrate placement portion is made projected at least 5 mm beyond the focus ring placement portion (39).

5. The substrate stage according to claim 1, wherein the oxide film on said side surface of said substrate placement portion is made of yttria.

6. A plasma processing apparatus (10) comprising the substrate stage according to any one of claims 1 to 5.

## Patentansprüche

1. Substratstufe, die für die Befestigung eines Substrats ausgelegt ist, das einer Plasmaverarbeitung unterzogen werden soll, wobei die Substratstufe umfasst:
einen Abschnitt zum Anbringen eines Fokussierrings (39), der ausgelegt ist für die Befestigung eines Fokussierrings (19), der den Umfang des auf der Substratstufe befestigen Substrats umschließt, und
einen Abschnitt zur Substratplatzierung, der über dem Abschnitt zum Anbringen eines Fokussierrings (39) an einer Stelle, die innerhalb des Abschnitts zum Anbringen eines Fokussierrings liegt, (39) vorsteht,
wobei der Abschnitt zur Substratplatzierung an dessen oberen Abschnitt mit einer elektrostatischen Haltevorrichtung (16) versehen ist, die eine Befestigungsfläche zum Anziehen und Halten des Substrats aufweist,
wobei auf der Seitenfläche des Abschnitts zur Substratplatzierung eine Oxidschicht mit einer vorher zu bestimmenden Schichtdicke ausgebildet ist, und auf dem Abschnitt zum Anbringen eines Fokussierrings (39) eine Beschichtung ausgebildet ist,
wobei die Substratstufe **dadurch gekennzeichnet ist, dass** die vorher zu bestimmende Schichtdicke der Oxidschicht auf der Seitenfläche des Abschnitts zur Substratplatzierung in einem Bereich von 1000 bis 2000 µm liegt, wobei die Oxidschicht aus einem Element der dritten Gruppe des Periodensystems gefertigt ist, und die Beschichtung des Abschnitts zum Anbringen eines Fokussierrings (39) eine Dicke in einem Bereich von 200 bis 500 µm aufweist.

2. Substratstufe gemäß Anspruch 1, wobei die Beschichtung des Abschnitts zum Anbringen eines Fokussierrings (39) so auf dem Abschnitt zum Anbringen eines Fokussierrings (39) ausgebildet ist, dass die Befestigungsfläche für den Fokussierring des Abschnitts zum Anbringen eines Fokussierrings (39) bedeckt ist.

3. Substratstufe gemäß Anspruch 1, wobei der Fokussiering ein ringförmiges aus einem dielektrischen Material gefertigtes Unterteil (20), und ein ringförmiges aus einem leitfähigen Material gefertigtes Oberteil (21), das auf dem Unterteil (21) angeordnet ist, umfasst, und
wobei das Oberteil (21) einen ersten flachen Abschnitt umfasst, der auf einer inneren Umfangsseite einer Oberseite des Oberteils (21) auf einer Höhe, die unter der Rückseite des Substrats liegt, ausgebildet ist,
und einen zweiten flachen Abschnitt umfasst, der auf einer äußeren Umfangsseite der Oberseite des Oberteils (21) ausgebildet ist, auf einer Höhe, die über der zu verarbeitenden Oberfläche des Substrats liegt, wenn der Fokussierring (19) auf dem Abschnitt zum Anbringen eines Fokussierrings (39) angebracht ist.

4. Substratstufe gemäß Anspruch 1, wobei der Abschnitt zur Substratplatzierung mindestens 5 mm über dem Abschnitt zum Anbringen eines Fokussierrings (39) vorsteht.

5. Substratstufe gemäß Anspruch 1, wobei die Oxidschicht auf der Seitenfläche des Abschnitts zur Substratplatzierung aus Yttriumoxid gefertigt ist.

6. Plasmaverarbeitungsvorrichtung (10), welche die Substratstufe gemäß einem der Ansprüche 1 bis 5 umfasst.

## Revendications

1. Platine pour substrat adaptée pour être montée avec un substrat qui doit être soumis à un traitement par plasma, comprenant une partie de placement de bague de mise au point (39) adaptée pour être montée avec une bague de mise au point (19) qui entoure une circonférence du substrat monté sur la platine pour substrat et une partie de placement de substrat faite de façon à dépasser au-delà de ladite partie de placement de bague de mise au point (39) à un emplacement vers l'intérieur de ladite partie de placement de bague de mise au point (39), ladite partie de placement de substrat étant pourvue au niveau de sa partie supérieure d'un mandrin électrostatique (16) ayant une surface de montage de celui-ci pour attirer et retenir le substrat,
dans laquelle ladite partie de placement de substrat est formée au niveau de sa surface latérale avec un film d'oxyde présentant une épaisseur prédéterminée de film,
et
dans laquelle ladite partie de placement de bague de mise au point (39) est formée avec un revêtement, **caractérisée en ce que** ladite épaisseur de film prédéterminée dudit film d'oxyde sur ladite surface latérale de ladite partie de placement de substrat est située dans une plage allant de 1000 à 2000 µm, ledit film d'oxyde étant fait d'un élément du groupe 3 du système périodique, et **en ce que** ledit revêtement sur ladite partie de placement de bague de mise au point (39) possède une épaisseur située dans une plage allant de 200 à 500 µm.

2. Platine pour substrat selon la revendication 1, dans laquelle le revêtement de ladite partie de placement de bague de mise au point (39) est formé sur ladite partie de placement de bague de mise au point (39) afin de recouvrir une surface de montage de bague de mise au point de ladite partie de placement de bague de mise au point (39).

3. Platine pour substrat selon la revendication 1, dans laquelle la bague de mise au point est composée d'un élément inférieur en forme de bague (20) fait d'un matériau diélectrique, et d'un élément supérieur en forme de bague (21) disposé sur l'élément inférieur (20) et fait d'un matériau conducteur, et
dans laquelle l'élément supérieur (21) comprend une première partie plate formée sur un côté périphérique interne d'une surface supérieure de l'élément supérieur (21) à une hauteur plus basse qu'une surface arrière du substrat et une seconde partie plate formée sur un côté périphérique externe de la surface supérieure de l'élément supérieur (21) à une hauteur plus élevée qu'une surface à traiter du substrat quand la bague de mise au point (19) est placée sur ladite partie de placement de bague de mise au point (39).

4. Platine pour substrat selon la revendication 1, dans laquelle la partie de placement de substrat est faite de façon à dépasser d'au moins 5 mm au-delà de la partie de placement de bague de mise au point (39).

5. Platine pour substrat selon la revendication 1, dans laquelle le film d'oxyde sur ladite surface latérale de ladite partie de placement de substrat est fait d'oxyde d'yttrium.

6. Appareil de traitement par plasma (10) comprenant la platine pour substrat selon l'une quelconque des revendications 1 à 5.
